# EUROPÄISCHE PATENTSCHRIFT

(11) **EP 1 890 586 B1**
(45) Veröffentlichungstag und Bekanntmachung des Hinweises auf die Patenterteilung: **02.02.2011**
(21) Anmeldenummer: 06753558.3
(22) Anmeldetag: 11.05.2006
(51) Int. Cl.: A47L 15/42

(54) **GESCHIRRSPÜLMASCHINE**
DISHWASHER
LAVE-VAISSELLE

(30) Priorität: 14.06.2005 DE 102005027572
(43) Veröffentlichungstag der Anmeldung: 27.02.2008
(73) Patentinhaber: Miele & Cie. KG, 33332 Gütersloh (DE)
(72) Erfinder: BULLER, Kai, 49219 Glandorf (DE); ENNEN, Günther, 32130 Enger (DE); KARA, Seyfettin, 32139 Spenge (DE); KORNBERGER, Martin, 33739 Bielefeld (DE); SEIFERT, Monika, 32760 Detmold (DE)
(86) Internationale Anmeldenummer: PCT/EP2006/004413
(87) Internationale Veröffentlichungsnummer: WO 2006/133778

(56) Entgegenhaltungen:
- WO-A-03/105073
- DE-C1- 4 041 144
- US-A- 5 834 745
- US-A1- 2001 020 578

## Beschreibung

Die Erfindung betrifft eine Geschirrspülmaschine mit einem durch eine schwenkbare Tür verschließbaren Spülbehälter, mit einem Bedienfeld, in dem Bedienelemente hinter einer verglasten Fläche angeordnet und durch Berührung der Fläche aktivierbar sind.

Bei aus dem Stand der Technik bekannten Spülmaschinen wird von der Frontseite her die Beladung bzw. die Entnahme des Geschirrs und Bestecks vorgenommen. Dabei sind die Bedienelemente von der Frontseite der Tür her zugänglich, so dass die Bedienelemente betätigt werden können, sobald die schwenkbare Tür verschlossen ist. Die Bedienelemente als solches, sowie das Display bei den bekannten Geschirrspülern, sind in der oberen Hälfte der Geschirrspülertür untergebracht. Somit sind sie für den Benutzer permanent zugänglich und sichtbar.

Als nachteilig bei dieser Art der Anbringung von Bedienelementen wird es angesehen, dass die Bedienelemente als solches das Erscheinungsbild des Geräts in Einfassung einer Küchenfront stören. Zudem wird es als nachteilig angesehen, dass die Bedienelemente aufgrund der vielfachen Betätigung zu Verschmutzungen neigen, wobei ihre Reinigung oft schwierig vorzunehmen ist. Ein weiteres Problem stellen die für die Bedienelemente notwendigen Durchbrüche dar, welche insbesondere bei wasserführenden Haushaltsgeräten das Eindringen von Feuchtigkeit ins Geräteinnere ermöglichen und so die dort angeordneten elektrischen und elektronischen Bauteile gefährden können.

Es sind beispielsweise aus der US 2005/0078027 A1 sogenannte Touchscreens bekannt, bei denen die Bedienelemente hinter einer Glasfläche liegen und mit Sensoren ausgestattet sind, die eine Berührung der Glasfläche im Bereich des jeweiligen Bedienelements erfassen und dann einen Schaltbefehl an eine Steuereinheit weitergeben.

Aus der DE 101 17 905 A1 ist ein Haushaltgerät mit einer Anzeigevorrichtung bekannt, bei der alle Anzeigen auf einer pixelweise elektrisch beeinflussbaren Materialschicht angeordnet sind und deshalb bedarfsweise zugeschaltet werden können.

Aus der US 5 589 958 A sind Küchenmöbel und -geräte bekannt, bei denen die optischen Eigenschaften der Sichtfenster zwischen transparent und intransparent wechselbar sind.

Die US 5,834,745 A offenbart ein Mikrowellengerät, bei dem das Bedienfeld aus einer mehrschichtigen Anordnung besteht, bei denen eine dunkle Schicht in einen lichtdurchlässigen Zustand geschaltet werden kann.

Der Erfindung stellt sich somit das Problem, eine Geschirrspülmaschine der eingangs genannten Art derart weiter zu bilden, dass sich insbesondere das Bedienelementfeld einerseits besser in die Türfront einfügt, wobei andererseits auch gewährleistet werden soll, dass das Bedienfeld wesentlich besser zu reinigen ist.

Erfindungsgemäß wird dieses Problem mit den Merkmalen des Anspruchs 1 gelöst, vorteilhafte Ausgestaltungen und Weiterbildungen der Erfindung ergeben sich aus den nachfolgenden Unteransprüchen.

Dass das Bedienfeld eine verglaste Fläche einnimmt, die optisch in transparent oder nicht transparent schaltbar ist, bringt viele Vorteile mit sich. Hierbei sieht die Geschirrspülmaschine durch das Ausblenden der Bedienelemente höherwertig aus, wobei sich zudem, weil es sich hierbei um eine glatte Fläche handelt, die Bedienoberfläche wesentlich besser reinigen lässt.

In vorteilhafter Weiterbildung wirkt die optisch schaltbare verglaste Fläche mit einem vom Benutzer aktivierbaren Schalter zusammen, so dass dieser selbst den Zeitpunkt der Aktivierung der Bedienelemente bestimmen kann. Durch die Ausbildung des Schalters als Näherungsschalter wird der Bedienkomfort noch mehr erhöht. Nähert sich also der Anwender der Maschine, so wird die verglaste Fläche durchsichtig, so dass die einzelnen Bedienelemente zu erkennen sind. Zusätzlich kann auch die optisch schaltbare verglaste Fläche mit der Zentralsteuereinheit des Geschirrspülers zusammenwirken, so dass der Anwender entsprechend der Programmschritte angezeigt bekommt, welchen Programmstatus die Maschine hat.

In vorteilhafter Weise können die einzelnen Bedienelemente nach Art eines Touchscreens ausgebildet sein, so dass infolge der Berührung eines Fingers die einzelnen Programmschritte angewählt werden können. Außerdem ist es sinnvoll, zusätzlich zur Transparent-Schaltung der verglasten Fläche eine Beleuchtungseinrichtung zu aktivieren, die dem Benutzer die Auswahl der einzelnen Bedienelemente erleichtert.

Ein Ausführungsbeispiel der Erfindung ist in den Zeichnungen rein schematisch dargestellt und wird nachfolgend näher beschrieben. Es zeigen:
- Figur 1: einen Ausschnitt aus dem oberen Bereich einer Geschirrspülmaschine in perspektivischer Darstellung;
- Figur 2: den Querschnitt durch das Bedienfeld 2 der Geschirrspülmaschine nach Figur 1;
- Figur 3: eine Darstellung des Bedienfelds in transparenter und in nicht transparenter Darstellung.

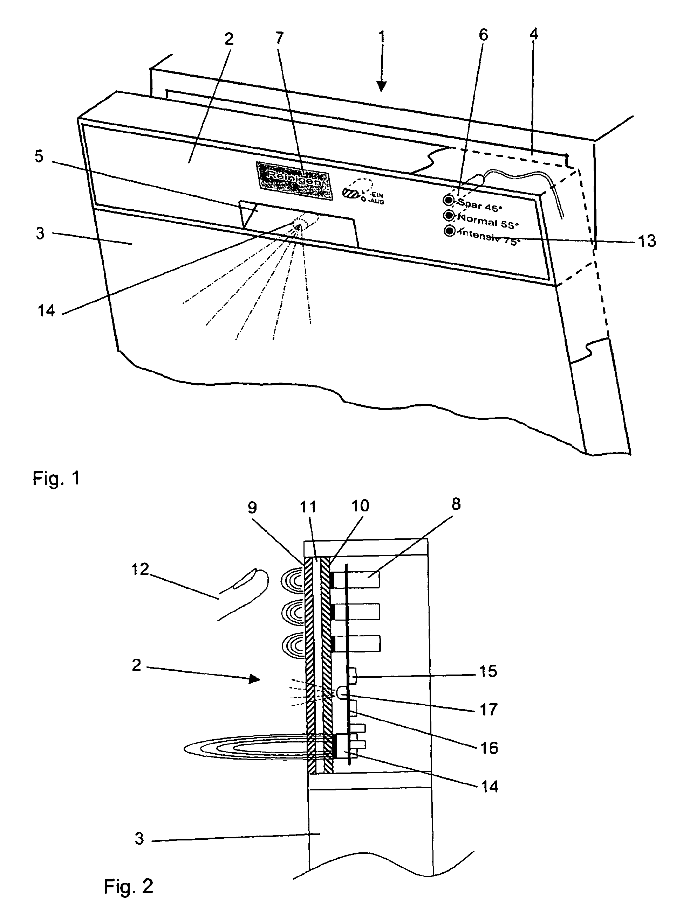

Die Figur 1 zeigt eine erfindungsgemäß ausgebildete Geschirrspülmaschine 1 mit einem Bedienfeld 2. Bei der Geschirrspülmaschine 1 ist das Bedienfeld 2 im oberen Bereich einer Tür 3 angeordnet, welche schwenkbar im unteren Bereich (nicht dargestellt) der Geschirrspülmaschine 1 gelagert ist und zum Verschließen des Spülbehälters 4 der Maschine dient. Die Tür 3 wird mit Hilfe eines Griffs 5 verschlossen, der ebenfalls im Bereich des Bedienfelds 2 angeordnet ist.

In dem Bedienfeld 2 sind Bedienelemente 6 angeordnet, mit denen das Einschalten der Maschine und eine Programmwahl ermöglicht wird. Weitere, in den Zeichnungen nicht dargestellte Elemente können zur Auswahl von Zusatz- oder sonstigen Funktionen dienen. Darüber hinaus ist in dem Bedienfeld eine Anzeigevorrichtung 7 vorhanden, mit der der Programmfortschritt des Geräts und gegebenenfalls weitere Informationen für den Benutzer dargestellt werden. Auch hier ist der Einsatz von weiteren Anzeigeelementen, welche beispielsweise eine Betätigung der Bedienelemente quittieren oder einen Geräte- oder Bedienfehler signalisieren, denkbar, aber nicht dargestellt.

Anstatt der herkömmlichen Schalter in der Blende finden nun kapazitive oder optische Sensoren 8 zur Programmwahl (Start, Vorwahl, etc.) Verwendung, die hinter einer Glasfläche angeordnet sind (9 bis 11), siehe hierzu Figur 2. Somit ist eine Bedienung nach Art eines Touchscreens möglich und es sind keine Durchbrüche in der Blende 2 mehr nötig, welches ein Reinigen derselben erleichtert. Kapazitive Sensoren reagieren auf die Änderung des Dielektrikums in ihrer unmittelbaren Umgebung. Kommt also ein Finger 12 oder Gegenstand in die Nähe des Sensors, so gibt dieser einen Schaltbefehl an die Gerätesteuerung weiter. Optische Sensoren verfügen oftmals über einen Sender oder einen Empfänger und reagieren auf den durch Reflektion zurück geworfenen Lichtstrahl. Das Licht geht durch eine durchsichtige Scheibe hindurch und trifft dann auf ein Hindernis (Finger 12 ), wird von diesem reflektiert und wieder vom Empfänger hinter dem Glas sensiert.

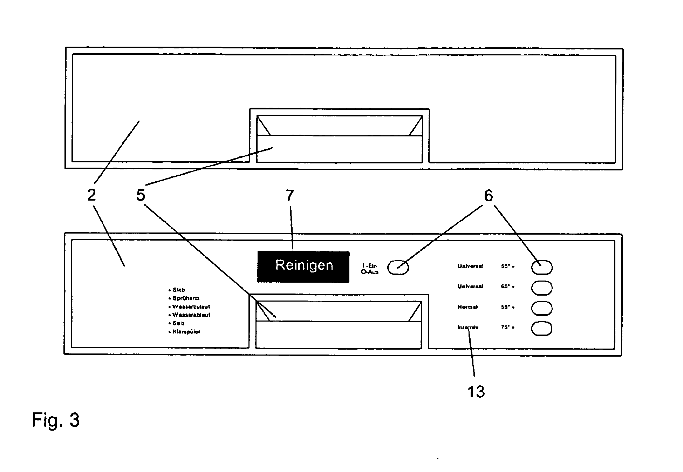

Die verglaste Fläche ist optisch schaltbar ausgebildet, so dass gemäß der Gegenüberstellung von Figur 3 die verglaste Fläche (9 bis 11), eine optische Änderung von intransparent (Figur 3 oben) in transparent (Figur unten) einnimmt. Hierzu wird zwischen einer äußeren Schutzschicht 9 aus transparentem Normalglas und einer inneren Schutzschicht 10, ebenfalls aus transparentem Normalglas, eine schaltbare Glasschicht 11 mit elektrochromen, gaschromen, hydrochromen, photochromen oder photoelektrochromen Eigenschaften eingesetzt. Die äußere Schutzschicht 9 schützt insbesondere die schaltbare Glasschicht 11 vor äußeren Einflüssen. Außerdem trägt sie vorzugsweise auf ihrer Rückseite Symbole und Beschriftungen, welche permanent sichtbar sein sollen, beispielsweise in den Zeichnungen nicht dargestellte Marken oder Gerätebezeichnungen. Auf der inneren Schutzschicht 10 ist eine Bedruckung 13 (s. Figur 1) angeordnet, mit der die Bedienelemente 6 beschriftet werden. Die einzelnen Bedienelemente 6 sind an der Rückseite der inneren Schutzschicht 10 angeordnet und reagieren auf Berührung der äußeren Schutzschicht 9 mit dem Finger.

Das Ein- oder Ausschalten der schaltbaren Glasschicht 11 erfolgt durch einen vom Benutzer aktivierbaren Schalter, der im Bereich des Griffs 5 angeordnet ist. Hierdurch ist eine Transparent-Schaltung des Bedienfelds und damit der Übergang in den Bedienmodus gewährleistet, wenn der Benutzer die Tür zum Einfüllen von Reiniger öffnet. Alternativ kann, wie in den Zeichnungen Figur 1 und 2 dargestellt, ein Näherungsschalter 14 eingesetzt werden, so dass der Benutzer keine weitere Bedienungshandlung zum Aktivieren des Bedienfelds 2 vornehmen muss. Zusätzlich zu dem Schalter 14 kann die schaltbare Glasschicht 11 mit der Gerätesteuerung 15 zusammenwirken, so dass während bestimmter Phasen oder während des gesamten Programmablaufs eine Kontrolle der Anzeigevorrichtung 7 und -elemente möglich ist. Außerdem kann die Gerätesteuerung 15 über ein Zeitmodul 16 selbsttätig die Intransparent-Schaltung vornehmen, so dass Energie gespart wird. Um dem Benutzer die Sicht auf die Bedienelemente 6 zu erleichtern, ist im Inneren der Bedienblende 2 eine Beleuchtungseinrichtung 17 vorgesehen, die parallel zur Transparent-Schaltung der verglasten Fläche (9 bis 11), eingeschaltet wird und mit der Intransparent-Schaltung abgeschaltet wird. Darüber hinaus ist eine permanente Transparent-Schaltung der verglasten Fläche (9 bis 11), möglich.

In der Grundeinstellung wird das Bedienfeld 2 sichtbar, sobald der Benutzer in die Nähe der Geschirrspülmaschine tritt. Erst dann werden auch die Bedienelemente 6 aktiviert und reagieren auf Berührung der äußeren Schutzschicht 9.

Die Einbauposition des Näherungs- oder Betätigungsschalters 14 ist abhängig von dessen Funktionsprinzip. Arbeitet der Schalter 14 mit einem optischen Sensor, so muss er die schaltbare Glasschicht 11 durchragen. Reagiert er dagegen auf ein akustisches oder elektromagnetisches Signal, so kann er hinter der schaltbaren Glasschicht 11 oder sogar hinter der inneren Schutzschicht 10 angeordnet sein. Seine Einbau-Position wird dann nur noch durch die Bedienfeld-Gestaltung bestimmt.

## Patentansprüche

1. Geschirrspülmaschine (1) mit einem durch eine schwenkbare Tür (3) verschließbaren Spülbehälter (4), mit einem Bedienfeld (2), in dem Bedienelemente (6) und/oder Anzeigeelemente (7) hinter einer verglasten Fläche (9 bis 11), angeordnet und durch Berührung der Fläche (9 bis 11), aktivierbar sind,
**dadurch gekennzeichnet,**
**dass** die verglaste Fläche (9 bis 11) optisch derart schaltbar ausgebildet ist, dass ihre optischen Eigenschaften zwischen transparent und intransparent wechselbar sind.

2. Geschirrspülmaschine (1) nach Anspruch 1,
**dadurch gekennzeichnet,**
**dass** die optisch schaltbare verglaste Fläche (9 bis 11) mit einem vom Benutzer aktivierbaren Schalter zusammenwirkt.

3. Geschirrspülmaschine (1) nach Anspruch 2,
**dadurch gekennzeichnet,**
**dass** der Schalter als Näherungsschalter (14) ausgebildet ist.

4. Geschirrspülmaschine (1) nach einem der Ansprüche 1 bis 3,
**dadurch gekennzeichnet,**
**dass** die optisch schaltbare verglaste Fläche (9 bis 11) mit der Gerätesteuerung (15) des Geräts zusammenwirkt.

5. Geschirrspülmaschine (1) nach einem der Ansprüche 1 bis 4,
**dadurch gekennzeichnet,**
**dass** die einzelnen Bedienelemente (6) nach Art eines Touchscreens ausgebildet sind.

6. Geschirrspülmaschine (1) nach einem der Ansprüche 1 bis 5,
**dadurch gekennzeichnet,**
**dass** mit der Transparent-Schaltung der verglasten Fläche (9 bis 11) die Einschaltung einer Beleuchtungseinrichtung (17) erfolgt.

## Claims

1. A dishwasher (1), including a washing tub (4) which can be closed by a pivotable door (3), and a control panel (2) in which control elements (6) and/or display elements (7) are arranged behind a glazed surface (9 through 11) and can be activated by touching the surface (9 through 11),
**characterized in, that** the glazed surface (9 through 11) is optically switchable such that its optical properties can be changed between transparent and opaque.

2. The dishwasher (1) as recited in claim 1,
**characterized in, that** the optically switchable, glazed surface (9 through 11) interacts with a user-activatable switch.

3. The dishwasher (1) as recited in claim 2,
**characterized in, that** the switch is in the form of a proximity switch (14).

4. The dishwasher (1) as recited in one of claims 1 through 3,
**characterized in, that** the optically switchable, glazed surface (9 through 11) interacts with the appliance controller (15) of the appliance.

5. The dishwasher (1) as recited in one of claims 1 through 4,
**characterized in, that** the individual control elements (6) are designed in the manner of a touch screen.

6. The dishwasher (1) as recited in one of claims 1 through 5,
**characterized in, that** switching of the glazed surface (9 through 11) to a transparent state at the same time activates a lighting device (17).

## Revendications

1. Lave-vaisselle (1) avec une cuve de lavage (4) pouvant être fermée par une porte (3) pivotante, avec une zone de commande (2) dans laquelle des éléments de commande (6) et/ou des éléments d'affichage (7) sont disposés derrière une surface (9 à 11) vitrée et peuvent être activés en touchant la surface (9 à 11),
**caractérisé en ce que** la surface (9 à 11) vitrée est constituée de façon optiquement commutable de sorte que ses caractéristiques optiques peuvent passer de l'état transparent et à l'état opaque.

2. Lave-vaisselle (1) selon la revendication 1,
**caractérisé en ce que**
la surface (9 à 11) vitrée commutable optiquement coopère avec un commutateur pouvant être activé par l'utilisateur.

3. Lave-vaisselle (1) selon la revendication 2,
**caractérisé en ce que**
le commutateur est constitué en tant que détecteur de proximité (14).

4. Lave-vaisselle (1) selon l'une des revendications 1 à 3,
**caractérisé en ce que**
la surface (9 à 11) vitrée commutable optiquement coopère avec la commande d'appareil (15) de l'appareil.

5. Lave-vaisselle (1) selon l'une des revendications 1 à 4,
**caractérisé en ce que**
les éléments individuels de commande (6) sont constitués à la façon d'un écran tactile.

6. Lave-vaisselle (1) selon l'une des revendications 1 à 5,
**caractérisé en ce que**
la mise en circuit d'un équipement d'éclairage (17) s'effectue avec la commutation de transparence de la surface (9 à 11) vitrée.
